# EUROPÄISCHE PATENTSCHRIFT

(11) **EP 0 931 343 B1**
(45) Veröffentlichungstag und Bekanntmachung des Hinweises auf die Patenterteilung: **07.08.2002**
(21) Anmeldenummer: 97942775.4
(22) Anmeldetag: 02.09.1997
(51) Int. Cl.: H01L 23/31, H01L 23/498, G06K 19/077

(54) **CHIPMODUL INSBESONDERE ZUR IMPLANTATION IN EINEN CHIPKARTENKÖRPER**
CHIP MODULE ESPECIALLY FOR IMPLANTATION IN CHIP CARD BODY
MODULE PUCE EN PARTICULIER POUR IMPLANTATION DANS UN CORPS DE CARTE A PUCE

(30) Priorität: 30.09.1996 DE 19640304
(43) Veröffentlichungstag der Anmeldung: 28.07.1999
(73) Patentinhaber: Infineon Technologies AG, 81669 München (DE)
(72) Erfinder: HOUDEAU, Detlef, D-84085 Langquaid (DE); STAMPKA, Peter, D-92421 Schwandorf-Klardorf (DE); HUBER, Michael, D-93152 Nittendorf (DE); HEITZER, Josef, D-93090 Bach (DE)
(74) Vertreter: Epping, Wilhelm, Dipl.-Ing.
(86) Internationale Anmeldenummer: DE9701921
(87) Internationale Veröffentlichungsnummer: WO9815004

(56) Entgegenhaltungen:
- EP-A- 0 424 530
- EP-A- 0 472 766
- FR-A- 2 670 930
- US-A- 5 258 650
- PATENT ABSTRACTS OF JAPAN vol. 008, no. 099 (E-243), 10.Mai 1984 & JP 59 016351 A (MATSUSHITA DENKI SANGYO KK), 27.Januar 1984,
- PATENT ABSTRACTS OF JAPAN vol. 007, no. 243 (E-207), 28.Oktober 1983 & JP 58 132954 A (MATSUSHITA DENKI SANGYO KK), 8.August 1983,

## Beschreibung

Die vorliegende Erfindung betrifft ein Chipmodul gemäß dem Oberbegriff des Patentanspruchs 1, d.h. ein Chipmodul, welches in einem Chipkartenkörper (25) implantierbar ist, mit einem Träger (10), auf dessen erster Hauptseite ein Chip aufgebracht ist, wobei der Träger auf einer zweiten, der ersten gegenüberliegenden Hauptseite Kontaktflächen zur externen Kontaktierung aufweist, und wobei auf dem Träger eine den Chip ganz oder teilweise umlaufende sockelartige Erhebung vorgesehen ist, auf welcher ein Versteifungsrahmen oder eine Gußform zum Ausbilden einer den Chip abdeckenden Chipabdeckung aufsetzbar ist.

Derartige Chipmodule sind in einer Vielzahl von verschiedenen Ausführungsformen bekannt. Eine gemäß dem Oberbegriff des Patentanspruchs 1 ausgebildete Ausführungsform ist beispielsweise in der FR 2 670 930 beschrieben.

Ferner ist aus der US 5,258,650 ein Halbleiterbauelement bekannt, bei dem eine zylinderförmige Anordnung auf eine ringförmige, sockelähnliche Metallisierung aufgebracht ist. Da ein innerhalb der ringförmigen Metallisierung vorgesehener Chip die Aufgabe übernimmt, einen sich im Inneren der zylinderförmigen Anordnung ändernden Druck zu erfassen, muß die zylinderförmige Anordnung hermetisch mit der Metallisierung verbunden sein. Die elektrische Kontaktierung des Chips mit außerhalb der zylinderförmigen Anordnung vorgesehenen Elementen ist deshalb schwer zu realisieren.

Kernstück eines jeden Chipmoduls ist, wie die Bezeichnung schon andeutet, ein (Halbleiter-)Chip. Dieser Chip wird mittels eines Klebers auf einen in der Regel aus Epoxidharz oder dergleichen gefertigten Träger geklebt und durch Bonden oder dergleichen mit auf dem Träger vorgesehenen leitenden Strukturen elektrisch verbunden.

Wenn das Chipmodul zum Einsatz in einer äußere Kontakstellen aufweisenden (kontaktbehafteten) Chipkarte vorgesehen ist, so umfassen die leitenden Strukturen des Trägers zumindest die Kontaktflächen (Oberflächenkontakte) der herzustellenden Chipkarte. Ist das Chipmodul zum Einsatz in einer nicht kontaktbehafteten, also kontaktlosen Chipkarte vorgesehen, so umfassen die leitenden Strukturen des Trägers zumindest solche Strukturen, die zum Anschluß an eine außerhalb des Chipmoduls angeordnete, genauer gesagt an eine im Chipkartenkörper integrierte Antenne vorgesehen ist.

Zum Schutz des Chips wird in der Regel ein denselben umgeben-Der, normalerweise metallischer Versteifungsrahmen auf den Träger aufgeklebt und mit einer den Chip und die Bonddrähte (vor mechanischen Beschädigungen und vor optischen Analysen) schützenden Masse aufgefüllt.

Das fertige Chipmodul wird abschließend in eine entsprechende Aussparung eines Chipkartenkörpers eingesetzt (implantiert), wodurch im Ergebnis eine gebrauchsfertige Chipkarte entsteht.

Handelt es sich bei der herzustellenden Chipkarte um eine kontaktbehaftete Chipkarte, so kann die Implantation des Chipmoduls in den Chipkartenkörper allein durch mechanisches Verbinden (Verkleben) von Chipmodul und Chipkartenkörper erfolgen. Für solche Anwendungen ausgebildete Chipmodule enthalten nämlich, wie vorstehend bereits erwähnt wurde, nicht nur den Chip selbst, sondern auch die an der fertigen Chipkarte außen liegenden Kontaktflächen (Oberflächenkontakte), so daß keine elektrische Verbindung zwischen dem Chipmodul und dem Chipkartenkörper erforderlich ist.

Handelt es sich bei der herzustellenden Chipkarte um eine kontaktlos betreibbare Chipkarte, so erfordert die Implantation des Chipmoduls in den Chipkartenkörper neben der mechanischen Verbindung von Chipmodul und Chipkartenkörper auch eine elektrische Verbindung derselben (um eine im Chipkartenkörper integrierte Antenne an den im Chipmodul enthaltenen Chip anzuschließen).

Die Erfahrung zeigt, daß insbesondere kontaktlose Chipkarten bisweilen überhaupt nicht oder nur eingeschränkt brauchbar sind.

Der vorliegenden Erfindung liegt daher die Aufgabe zugrunde, das Chipmodul gemäß dem Oberbegriff des Patentanspruchs 1 derart weiterzubilden, daß kontaktlos betreibbare Chipkarten unter Verwendung desselben auf äußerst einfache Weise zuverlässig fehlerfrei herstellbar sind.

Diese Aufgabe wird erfindungsgemäß durch die im kennzeichnenden Teil des Patentanspruchs 1 beanspruchten Merkmale gelöst.

Demnach sind elektrische Leiterbahnen auf der ersten Hauptseite des Trägers aufgebracht und die elektrischen Leiterbahnen sind an den Stellen, wo sie mit der Erhebung zusammentreffen, Bestandteil der Erhebung.

Durch das Vorsehen der besagten Erhebung kann für den Ver-Steifungsrahmen eine Auflagefläche geschaffen werden, auf welche dieser unabhängig von sonstigen Strukturen auf der betreffenden Oberfläche des Trägers des Chipmoduls groß-Flächig und in einer genau definierten Lage aufsetzbar ist.

Damit kann zuverlässig ausgeschlossen werden, daß leitende Strukturen wie Leiterbahnen und dergleichen, welche auf derjenigen Oberfläche des Trägers des Chipmoduls verlaufen, auf welcher der Versteifungsrahmen anzuordnen ist, durch diesen elektrisch kurzgeschlossen oder in sonstiger Weise negativ beeinflußt werden.

Dies gilt selbst dann, wenn zumindest Teile der Erhebung durch die besagten, vor Kurzschlüssen zu schützenden leitenden Strukturen selbst gebildet werden und der Versteifungsrahmen "nur einfach" auf die Erhebung aufgeklebt wird. Insbesondere die großflächige und gleichmäßig verteilte Auflagemöglichkeit, die die Erhebung für den Versteifungsrahmen bieten kann, sorgt nämlich dafür, daß der Versteifungsrahmen rundum nur mittelbar über den (vorzugsweise isolierenden) Kleber mit der Erhebung in Verbindung kommen kann.

Die rundum im wesentlichen unterbrechungsfreie und ebene Auflagefläche, die die Erhebung für den Versteifungsrahmen bereitstellen kann, sorgt darüber hinaus dafür, daß zwischen dem Versteifungsrahmen und der Auflagefläche, auf welcher dieser aufgesetzt wird, keine oder jedenfalls keine solchen Lücken entstehen können, die nicht durch den Kleber, durch welchen der Versteifungsrahmen auf die Erhebung geklebt wird, mehr oder weniger vollständig aufgefüllt werden können. Dadurch kann erreicht werden, daß eine zur Herstellung eines sogenannten Globe Top vorgesehene Abdeckmasse, mit welcher das Innere des Versteifungsrahmens mehr oder weniger vollständig aufgefüllt wird, nicht nach außen entweichen kann. Dies wiederum hat den positiven Effekt, daß anders als bisher keine Gefahr besteht, daß außerhalb des Versteifungsrahmens verlaufende leitende Strukturen, welche elektrisch mit außerhalb des Chipmoduls befindlichen Chipkarten-Komponenten zu verbinden sind, von einer aus dem Versteifungsrahmen entweichenden Abdeckmasse überzogen und dadurch für elektrische Verbindungen unbrauchbar gemacht werden.

Leitende Strukturen, die auf derjenigen Seite des Trägers vorgesehen sind, auf welche auch der Versteifungsrahmen aufzusetzen ist, werden durch den Versteifungsrahmen also weder in ihren elektrischen Eigenschaften noch in ihren mechanischen Eigenschaften negativ beeinflußt.

Damit bleiben insbesondere auch diejenigen leitenden Strukturen unbeeinflußt, die zur Verbindung des im Chipmodul enthaltenen Chips mit der im Chipkartenkörper integrierten Antenne dienen.

Entsprechendes gilt für den Fall, daß der Chip ohne Vorsehen eines Versteifungsrahmens mit einer entsprechend festen (steifen) Abdeckmasse wie einer Moldmasse, einer thermisch aushärtenden Abdeckmasse oder dergleichen bedeckt wird. In diesem Fall ist die Erhebung als An- und/oder Auflagefläche für eine Gußform oder sonstige Hilfsmittel verwendbar. Damit kann auch in diesem Fall gewährleistet werden, daß maximal solche Spalte oder Unterbrechungen zwischen der Gußform und dem Träger vorhanden sind bzw. offen bleiben, welche von der verwendeten Abdeckmasse nicht durchdrungen werden können.

Es wurde mithin ein Chipmodul geschaffen, durch welches insbesondere Chipkarten, deren Chipmodule elektrisch mit dem Chipkartenkörper verbunden werden müssen, also unter anderem auch kontaktlos betreibbare Chipkarten unter Verwendung desselben auf äußerst einfache Weise zuverlässig fehlerfrei herstellbar sind.

Vorteilhafte Weiterbildungen der Erfindung sind Gegenstand der Unteransprüche.

Die Erfindung wird nachfolgend anhand eines Ausführungsbeispiels unter Bezugnahme auf die Zeichnung näher erläutert. Es zeigen
- Figur 1: eine Draufsicht auf ein Trägerband mit einer Vielzahl von teilweise fertiggestellten erfindungsgemäßen Chipmodulen,
- Figur 2: eine stufenweise durch verschiedene Ebenen verlaufende Schnittansicht durch ein komplett fertiggestelltes erfindungsgemäßes Chipmodul, und
- Figur 3: eine stark schematisierte Schnittansicht eines Chipkartenkörpers mit einem in diesen eingesetzten erfindungsgemäßen Chipmodul.

Das erfindungsgemäße Chipmodul ist wie die herkömmlichen Chipmodule in Chipkartenkörper einsetzbar, wodurch im Ergebnis eine Chipkarte entsteht. Chipmodule dieser Art sind jedoch nicht nur für die derzeit gebräuchlichen "normalen" Chipkarten wie Telefonkarten, Authentisierungskarten und dergleichen, sondern generell für Chips enthaltende Karten oder Module jeder Art verwendbar, also beispielsweise auch für die sogenannten SIM-Module für Mobiltelefone etc.

Das im folgenden beschriebene Chipmodul eignet sich zur Herstellung einer Chipkarte, welche sowohl als kontaktbehaftete als auch als kontaktlose Chipkarte verwendbar ist. Derartige Chipkarten werden im folgenden der Einfachheit halber als Kombikarten bezeichnet.

Kombikarten zeichnen sich dadurch aus, daß sie einerseits an vorbestimmten Stellen äußere Anschlußmöglichkeiten in Form von Oberflächenkontakten zur drahtgebundenen Informationsübertragung, und andererseits eine Antenne zur drahtlosen Informationsübertragung aufweisen.

Die Oberflächenkontakte sind im Chipmodul integriert, wohingegen die Antenne im Chipkartenkörper enthalten ist und mit entsprechenden Anschlüssen des Chipmoduls (dessen Chips) elektrisch verbunden werden muß.

Obgleich sich das nachstehend beschriebene Chipmodul insbesondere für den Einsatz in Kombikarten und kontaktlos betreibbaren Chipkarten eignet, sind erfindungsgemäß ausgebildete Chipmodule grundsätzlich auch in beliebigen anderen Chipkarten und -modulen vorteilhaft einsetzbar.

Das im folgenden näher beschriebene Chipmodul ist in den Figuren mit dem Bezugszeichen 1 bezeichnet. Das Chipmodul 1 ist eines einer Vielzahl von Chipmodulen die hintereinander und nebeneinander liegend auf einem Träger 10 ausgebildet werden.

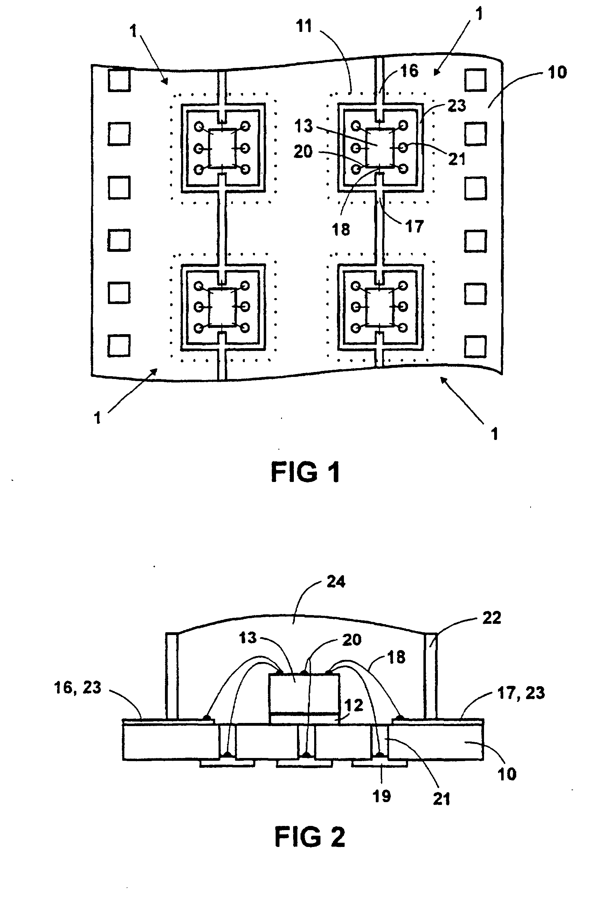

Als Träger 10 wird vorzugsweise ein Trägerband verwendet. Ein Ausschnitt eines solchen Trägerbandes mit vier noch in der Herstellung befindlichen Chipmodulen 1 ist in der Figur 1 gezeigt.

Das (aus einem elektrisch isolierenden Epoxidharz bestehende) Trägerband weist seitliche Perforationslöcher auf, welche einen einfachen und zuverlässigen Transport des Trägerbandes während der Herstellung der Chipmodule 1 ermöglicht. Auf dem gezeigten Ausschnitt des Trägerbandes sind vier Chipmodule 1 ausgebildet, welche nach deren Fertigstellung durch Zerschneiden bzw. Zersägen des Trägerbandes längs in der Figur 1 gepunktet eingezeichneter Schnittlinien 11 vereinzelt werden.

Der Aufbau eines jeden Chipmoduls 1 ist aus der Figur 1 (Draufsicht) und aus der Figur 2 (seitliche Schnittansicht) ersichtlich; in der Figur 2 wurden, obgleich es sich um eine Schnittdarstellung handelt, aus Gründen der besseren Übersichtlichkeit keine Schraffuren eingezeichnet.

Das Herzstück eines jeden Chipmoduls 1 ist ein auf den Träger 10 durch einen Kleber 12 aufgeklebter Chip 13. Dieser Chip 13 ist vorzugsweise durch Bonden mit auf dem Träger 10 oder innerhalb des Trägers 10 vorgesehenen leitenden Strukturen verbunden.

Die leitenden Strukturen befinden sich im betrachteten Beispiel sowohl auf der Seite des Trägers 10, auf welcher der Chip 13 angeordnet ist, als auch auf der dieser Seite gegenüberliegenden Seite des Trägers 10. Diejenige Seite des Trägers 10, auf welcher der Chip 13 angeordnet ist, wird im folgenden als die Chipseite 14 des Trägers 10 bezeichnet, und die der Chipseite 14 gegenüberliegende Seite des Trägers 10 wird als dessen Kontaktflächenseite 15 bezeichnet.

Die auf der Chipseite 14 des Trägers 10 ausgebildeten leitenden Strukturen bestehen aus einer diesseits des Chips 13 verlaufenden ersten Leiterbahn 16 und einer jenseits des Chips 13 verlaufenden zweiten Leiterbahn 17, über welche eine im Chipkartenkörper vorgesehene Antenne mit dem Chip 13 verbindbar ist; die Leiterbahnen 16 und 17 sind über Bonddrähte 18 mit entsprechenden Anschlüssen des Chips 13 verbunden.

Die auf der Kontaktflächenseite 15 des Trägers 10 ausgebildeten leitenden Strukturen sind Kontaktflächen (Oberflächenkontakte) 19 ausgebildet, über welche die das beschriebene Chipmodul 1 enthaltende Chipkarte später kontaktierbar sein wird; die Kontaktflächen 19 sind über Bonddrähte 20 mit entsprechenden Anschlüssen des Chips 13 verbunden, wobei die Bonddrähte 20 jeweils durch im Träger 10 vorgesehene Bondlöcher 21 verlaufen.

Die Anschlüsse des Chips 13, über welche dieser über die Leiterbahnen 16 und 17 mit der Antenne zu verbinden ist, sind nicht zugleich solche Anschlüsse, die mit den Anschlußstellen 19 zu verbinden sind. Dadurch kann verhindert werden, daß die Antennenanschlüsse des Chips über die Anschlußstellen 19 kurzgeschlossen werden.

Der Chip 13 ist von einem Versteifungsrahmen 22 umgeben, welcher auf eine auf dem Träger 10 ausgebildete sockelartige Erhebung in Form eines Rahmenträgers 23 aufgesetzt ist.

Der Rahmenträgen 23 umläuft den Chip 13 im wesentlichen vollständig; er besteht aus dem selben Material wie die auf der selben Seite des Trägers 10, d.h. auf der Chipseite 14 vorgesehenen Leiterbahnen 16 und 17 und wird auf die selbe Art und Weise zusammen mit diesen hergestellt.

Dort, wo die Leiterbahnen 16 und 17 unter dem Versteifungsrahmen 22 hindurchlaufen, bilden diese zugleich einen Teil des Rahmenträgers 23. Die durch die Leiterbahnen 16 und 17 gebildeten Rahmenträgerteile und die nicht durch die Leiterbahnen 16 und 17 gebildeten Rahmenträgerteile weisen die selbe Höhe auf und bilden dadurch eine ebene Auflagefläche, auf welche der Versteifungsrahmen 22 großflächig und genau definiert, d.h. insbesondere kippfrei aufgesetzt werden kann. Alternativ kann vorgesehen werden, die Leiterbahnen 16 und 17 etwas niedriger auszubilden als die diejenigen Teile des Rahmenträgers 23, die nicht durch die Leiterbahnen 16 und 17 gebildet werden.

Damit die Leiterbahnen 16 und 17 durch die nicht durch diese gebildeten, ebenfalls metallischen Rahmenträgerabschnitte nicht kurzgeschlossen oder in sonstiger Weise elektrisch beeinflußt werden, sind im Rahmenträger 23 entsprechende Unterbrechungen (Spalte) vorgesehen.

Diese, in den Figuren nicht dargestellten Unterbrechungen sind vorzugsweise (aber nicht unbedingt) unmittelbar neben den Leiterbahnen 16 und 17, d.h. zwischen den Rahmenträgerteilen, die durch die Leiterbahnen 16 und 17 gebildet werden und den Rahmenträgerteilen, die nicht durch die Leiterbahnen 16 und 17 gebildet werden, vorgesehen. Dadurch kann verhindert werden, daß die physikalischen Eigenschaften der Leiterbahnen 16 und 17, insbesondere deren kapazitive und induktive Widerstände übermäßig verändert werden. Grundsätzlich können jedoch beliebig viele und an beliebigen Stellen des Rahmenträgers 23 ausgebildete Unterbrechungen vorgesehen sein.

Die Breite und/oder die Form der Unterbrechungen sind so zu bemessen, daß einerseits eine gute elektrische Isolierungswirkung erzielt wird und daß andererseits nur ein solcher Spalt gebildet wird, durch welchen eine später noch genauer beschriebene Abdeckmasse nicht entweichen kann. Im betrachteten Beispiel liegt die Breite der Unterbrechung vorzugsweise im Bereich zwischen 10 µm und 100 µm.

Zur Befestigung des Versteifungsrahmens 22 auf dem beschriebenen Rahmenträger 23 wird ein elektrisch isolierender Kleber verwendet. Die Dicke der zwischen dem Rahmenträger 23 und dem Versteifungsrahmen 22 einbringbaren Kleberschicht variiert zwischen 10 µm und 35 µm, ist aber - jedenfalls bei Vorsehen des beschriebenen Rahmenträgers 23 - groß genug, um zu verhindern, daß die Leiterbahnen 16 und 17, die ja Teile des Rahmenträgers 23 bilden, durch den in der Regel metallischen Versteifungsrahmen 22 kurzgeschlossen werden. Die relativ geringe Dicke der zwischen den Rahmenträger 23 und den Versteifungsrahmen 22 einbringbaren Kleberschicht reicht insbesondere deshalb für eine gute Isolationswirkung aus, weil der Versteifungsrahmen 22 über dem im wesentlichen ebenen Rahmenträger 23 großflächig aufliegen und - anders als ohne Vorsehen des Rahmenträgers 23 - nicht über die von der Oberfläche des Trägers 10 emporragenden Leiterbahnen 16 und 17 unter lokaler Verringerung der Kleberschichtdicke zur Seite kippen kann.

Sofern die vorstehend erwähnten Unterbrechungen im Rahmenträger 23 nicht zu breit sind, werden diese beim Aufkleben des Versteifungsrahmens 22 auf den Rahmenträger 23 durch den isolierenden Kleber geschlossen.

Der innerhalb des Versteifungsrahmens 22 liegende Bereich wird mit einer den Chip 13 und die Bonddrähte 18 und 20 vor mechanischen Beschädigungen und optischen Analysen schützenden Abdeckmasse 24 aufgefüllt; dadurch wird ein sogenanntes Globe Top hergestellt.

Die Abdeckmasse 24 kann aus dem vom Versteifungsrahmen 22 und dem Rahmenträger 23 umschlossenen Innenraum nicht entweichen, weil zwischen dem Versteifungsrahmen 22 und dem Rahmenträger 23 keine oder jedenfalls keine solchen Öffnungen vorhanden sind, die ein Austreten der Abdeckmasse 24 erlauben. Der Versteifungsrahmen 22, der Rahmenträger 23 und die Verbindung zwischen denselben sind im wesentlichen lückenlos dicht; gegebenenfalls vorhandene Öffnungen sind so geformt und/oder bemessen, daß sie nicht oder allenfalls nur in vernachlässigbarem Umfang von der Abdeckmasse 24 durchdrungen werden können. Die (elektrisch isolierende) Abdeckmasse 24 kann daher nicht auf außerhalb des Versteifungsrahmens 22 verlaufende leitende Strukturen wie die Leiterbahnen 16 und 17 gelangen, wodurch als Kontaktstellen zu verwendende Abschnitte derselben anders als bisher nicht in ihrer Funktion beeinträchtigt werden können.

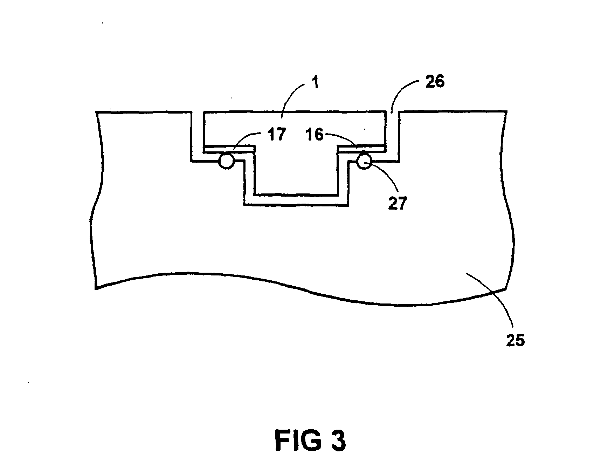

Das Chipmodul wird nach dessen Fertigstellung wie in der Figur 3 schematisch dargestellt in eine entsprechende Aussparung eines Chipkartenkörpers eingesetzt.

Die Figur 3 ist eine stark vereinfachte Darstellung, in welcher insbesondere das Chipmodul 1 nur stark schematisiert dargestellt ist. Darüber hinaus sind, obgleich es sich um eine Schnittansicht handelt, aus Gründen der Übersichtlichkeit keine Schraffuren eingezeichnet.

Der Chipkartenkörper ist in der Figur 3 mit dem Bezugszeichen 25, und die darin zum Einsetzen des Chipmoduls 1 vorgesehene Aussparung mit dem Bezugszeichen 26 bezeichnet.

Durch die Aussparung 26 hindurch verlaufen elektrisch leitende Strukturen in Form von zwei zumindest teilweise freiliegenden bzw. freigelegten (Antennenanschluß-)Leitungen 27, welche zu einer im Chipkartenkörper 25 integrierten Antenne gehören oder führen.

Beim Einsetzen des Chipmoduls 1 in die Aussparung 26 des Chipkartenkörpers 25 kommen die elektrisch leitenden Strukturen des Chipmoduls 1, d.h. die Leiterbahnen 16 und 17 zumindest teilweise in eine frontale Gegenüberlage zu den elektrisch leitenden Strukturen des Chipkartenkörpers 25, d.h. zu den Antennenanschlußleitungen 27; die Leiterbahnen 16 und 17 kommen dabei über oder - wie in der Figur 3 gezeigt ist - sogar auf den Antennenanschlußleitungen 27 zu liegen.

Setzt man das Chipmodul 1 wie beschrieben in die Aussparung 26 des Chipkartenkörpers 25 ein, so kommen die auf der Kontaktflächenseite 15 des Trägers 10 ausgebildeten Kontaktflächen 19 des Chipmoduls 1 automatisch auf der Außenseite der Chipkarte zu liegen.

Das Chipmodul 1 wird in der in der Figur 3 gezeigten Stellung mit dem Chipkartenkörper verklebt.

Die Leiterbahnen 16 und 17 und die Antennenanschlußleitungen 27 werden durch eine geeignete Verbindungstechnik zusätzlich elektrisch miteinander verbunden. Dies kann beispielsweise dadurch bewerkstelligt werden, daß eine an der gewünschten Verbindungsstelle vorgesehene Lötpaste von außen durch den Träger 10 hindurch mittels eines Lasers auf die Schmelztemperatur erhitzt wird. Sofern die Leiterbahnen 16 und 17 und die.Antennenanschlußleitungen 27 wie in Figur 3 gezeigt direkt aufeinander liegen, befinden sie schon allein dadurch in Kontakt miteinander, so daß auf eine zusätzliche Verbindung durch Verlöten oder dergleichen verzichtet werden kann; nichtsdestotrotz können sie selbstverständlich gleichwohl miteinander verlötet werden.

Die Leiterbahnen 16 und 17 und/oder die Kontaktflächen 19 sind, falls eine separate Verbindung zwischen den Leiterbahnen 16 und 17 und den Antennenanschlußleitungen 27 beabsichtigt ist, vorzugsweise so angeordnet und ausgebildet, daß die Kontaktflächen 19 das Erhitzen der Lötpaste nicht behindern. Insbesondere sind die Leiterbahnen 16 und 17 und/oder die Kontaktflächen 19 derart angeordnet, daß die Abschnitte der Leiterbahnen 16 und 17, die mit den Antennenanschlußleitungen 27 zu verbinden (zu verlöten) sind, unter Zwischenräumen zwischen den Anschlußstellen 19 zu liegen kommen; die normalerweise sehr schmalem Zwischenräume zwischen den Anschlußstellen (die Standardbreite beträgt 0,2 mm) werden an den entsprechenden Stellen vorzugsweise lokal breiter ausgeführt.

Das vorstehend hinsichtlich des Aufbaus beschriebene erfindungsgemäße Chipmodul 1 wird wie folgt hergestellt:

Ausgangspunkt ist ein Trägerband, das weder die Bondlöcher 21 noch irgendwelche leitenden Strukturen auf seinen Oberflächen aufweist und vorzugsweise noch beim Trägerbandhersteller mit denselben versehen wird.

Die Bondlöcher 21 werden durch Bohren oder Stanzen erzeugt.

Die leitenden Strukturen, genauer gesagt die Leiterbahnen 16 und 17 sowie die Kontaktflächen 19 werden unter Verwendung einer elektrisch leitenden Folie erzeugt, welche auf das Trägerband nachträglich aufbringbar ist. Zusammen mit der Herstellung der genannten leitenden Strukturen wird auch der Rahmenträger 23 hergestellt; der Rahmenträger 23 ist damit im betrachteten Beispiel ebenfalls eine leitende Struktur, welche jedoch nicht als solche verwendet wird.

Die elektrisch leitende Folie (im betrachteten Beispiel eine Kupferfolie), durch welche bzw. aus welcher die Leiterbahnen 16 und 17, die Kontaktflächen 19 und der Rahmenträger 23 gebildet bzw. hergestellt werden, wird ohne zusätzlichen Kleber auf die entsprechenden Seiten des Trägerbandes auflaminiert. Die leitende Folie kann wahlweise schon die erforderliche Struktur aufweisen oder aber erst nachträglich, d.h. erst nach dem Auflaminieren auf das Trägerband entsprechend strukturiert werden.

Beim nachträglichen Strukturieren werden die nicht benötigten Abschnitte der leitenden Folie jeweils chemisch, d.h. beispielsweise durch selektives Ätzen entfernt. Die leitende Folie wird dadurch auf die gewünschte Geometrie reduziert. Im Ergebnis bleiben von der leitenden Folie auf der Kontaktflächenseite 15 die Kontaktflächen 19 und auf der Chipseite 14 die Leiterbahnen 16 und 17 sowie der Rahmenträger 23 übrig.

Die Leiterbahnen 16 und 17 von auf dem Trägerband benachbarten Chipmodulen sind, wie aus der Figur 1 ersichtlich ist, zu einem durchgehenden Leiterbahnabschnitt zusammengefaßt. Dies ist problemlos möglich, weil der durchgehende Leiterbahnabschnitt beim Vereinzeln der Chipmodule (Heraustrennen der Chipmodule aus dem Trägerband längs der Schnittlinien 11) ohnehin durchtrennt wird.

Im Anschluß an das Aufbringen und das gegebenenfalls erforderliche Strukturieren der leitenden Folie wird diese einer galvanischen Veredelung unterzogen. Im betrachteten Ausführungsbeispiel wird dabei auf die durch die leitende Folie gebildete Kupferschicht zunächst eine Nickelschicht, und auf diese eine Goldschicht aufgebracht. Bei den Kontaktflächen 19 geschieht dies an denjenigen Stellen, wo sich die Bondlöcher 21 befinden, von beiden Seiten der die Kontaktflächen bildenden Kupferschicht. Anstelle des Schichtaufbaus Cu-Ni-Au kann auch ein Schichtaufbau Au-Ni-Cu-Ag oder ein sonstiger bondfähiger Schichtaufbau vorgesehen werden.

Sämtliche leitenden Strukturen auf dem Trägerband werden auf exakt die selbe Art und Weise hergestellt. Für die Leiterbahnen 16 und 17 sowie den Rahmenträger 23 bedeutet dies, daß diese exakt die selbe Höhe und exakt die selben physikalischen und chemischen Eigenschaften aufweisen.

Auf das wie beschrieben vorbereitete Trägerband werden sodann die Chips 13 aufgeklebt und durch Bonden mit den Kontaktflächen 19 und den innerhalb des Rahmenträgers verlaufenden Leiterbahnabschnitten elektrisch verbunden.

Im Anschluß daran wird der Versteifungsrahmen 22 mittels eines elektrisch isolierenden Klebers auf den Rahmenträger 23 aufgeklebt.

Bedingt durch das Vorsehen eines Rahmenträgers im allgemeinen und dessen besondere Gestaltung im besonderen ist zwischen dem Versteifungsrahmen 22 und dem Rahmenträger 23 eine rundum lückenlose und dichte Verbindung herstellbar, durch welche der Versteifungsrahmen und der Rahmenträger zuverlässig voneinander elektrisch isoliert sind; die Leiterbahnen 16 und 17 können weder durch den Versteifungsrahmen 22 noch durch den Rahmenträger 23 kurzgeschlossen werden.

Der vom Versteifungsrahmen 22 umschlossene Bereich wird sodann mehr oder weniger vollständig mit der Abdeckmasse 24 aufgefüllt.

Abschließend werden die auf die beschriebene Art und Weise hergestellten Chipmodule aus dem Trägerband ausgeschnitten und wie in der Figur 3 gezeigt in jeweilige Chipkartenkörper 25 eingesetzt und mit diesen mechanisch und gegebenenfalls auch elektrisch verbunden.

Das vorstehend hinsichtlich des Aufbaus und der Herstellung beschriebene Chipmodul ist ein Chipmodul ohne Chipinsel, d.h. ein Chipmodul, bei welchem der Chip auf den Träger aufgesetzt ist. Die Erfindung ist jedoch prinzipiell auch bei Chipmodulen mit Chipinseln, d.h. bei Chipmodulen, bei welchen der Chip in eine im Träger vorgesehene Aussparung eingesetzt wird, anwendbar.

Der Rahmenträger 23 ist nicht nur zum Aufsetzen eines Versteifungsrahmens 22 verwendbar; er kann auch dann wertvolle Dienste leisten, wenn kein Versteifungsrahmen vorgesehen wird. Auf den besagten Versteifungsrahmen 22 kann unter anderem verzichtet werden, wenn der Chip mit einer Abdeckmasse bedeckt wird, die wie beispielsweise eine Moldmasse, eine thermisch aushärtende Abdeckmasse oder dergleichen ohne den Versteifungsrahmen verarbeitet werden kann und selbst entsprechend fest (steif) wird. In diesem Fall kann die sockelartige Erhebung in Form des zuvor ausführlich beschriebenen Rahmenträgers 23 zum An- und/oder Aufsetzen von Gußformen oder sonstigen Hilfsmitteln dienen. Das Herstellen der Chipabdeckung unter Verwendung des Rahmenträgers 23 ist dabei in zweifacher Hinsicht vorteilhaft: einerseits ist dadurch verhinderbar, daß die Chipabdeckung schief und/oder in sonstiger Weise abweichend von einer vorgegebenen Sollposition und/oder Sollausrichtung gefertigt wird, und andererseits kann auch hier (aus im wesentlichen den selben Gründen wie im Fall des Vorsehens eines Versteifungsrahmens) verhindert werden, daß außerhalb der eigentlichen Chipabdeckung verlaufende Abschnitte der Leiterbahnen 16 und 17 mit Abdeckmasse bedeckt und damit unbrauchbar für Verbindungen mit außerhalb des Chipmoduls vorgesehenen Komponenten gemacht werden.

Es ist auch nicht erforderlich, daß die Leiterbahnen 16 und 17 Leiterbahnen zum Verbinden des Chipmoduls mit einer außerhalb desselben vorgesehenen Antenne (Spule) sind; die sockelartige Erhebung in Form des Rahmenträgers 23 und/oder die beschriebene elektrische Verbindung zwischen dem Chipmodul und dem Chipkartenkörper sind auch dann vorteilhaft einsetzbar, wenn die Leiterbahnen 16 und 17 eine beliebige andere Funktion als die vorstehend beschriebene haben.

Wenngleich es besonders einfach und elegant ist, die sockelartige Erhebung wie die Leiterbahnen 16 und 17 und die Kontaktflächen 19 zusammen mit diesen herzustellen, so besteht auch hierauf keine Einschränkung. Die sockelartige Erhebung kann grundsätzlich unabhängig von den Leiterbahnen 16 und 17 aus jedem beliebigen Material auf beliebige Art und Weise hergestellt sein.

Zusammenfassend kann festgestellt werden, daß mit dem beschriebenen Chipmodul insbesondere kontaktlose Chipkarten, aber auch andere Chipkarten wesentlich zuverlässiger als bisher fehlerfrei herstellbar sind.

## Patentansprüche

1. Chipmodul, welches in einen Chipkartenkörper (25) implantierbar ist, mit einem Träger (10), auf dessen erster Hauptseite ein Chip (13)aufgebracht ist, wobei der Träger auf einer zweiten, der ersten gegenüberliegenden Hauptseite Kontaktflächen (19) zur externen Kontaktierung aufweist, und wobei auf dem Träger eine den Chip (13) ganz oder teilweise umlaufende sockelartige Erhebung (23) vorgesehenen ist, auf welcher ein Versteifungsrahmen (22) oder eine Gußform zum Ausbilden einer den Chip (13) abdeckenden Chipabdeckung aufsetzbar ist,
**dadurch gekennzeichnet,**
**daß** elektrische Leiterbahnen (16, 17) auf der ersten Hauptseite des Trägers (10) aufgebracht sind und an den Stellen, wo sie mit der Erhebung (23) zusammentreffen, Bestandteil der Erhebung sind.

2. Chipmodul nach Anspruch 1,
**dadurch gekennzeichnet,**
**daß** die Erhebung (23) durch eine auf dem Träger (10) aufgebrachte, elektrisch leitende Struktur gebildet wird.

3. Chipmodul nach Anspruch 1 oder 2,
**dadurch gekennzeichnet,**
**daß** die Erhebung (23) ein den Chip im wesentlichen vollständig umlaufender Rahmenträger ist.

4. Chipmodul nach einem der vorstehenden Ansprüche,
**dadurch gekennzeichnet,**
**daß** die Erhebung (23) derart ausgebildete und angeordnete Unterbrechungen aufweist, daß Teile der Erhebung, die durch die elektrischen Leiterbahnen (16, 17) gebildet werden, nicht durch Teile der Erhebung, welche nicht durch die elektrischen Leiterbahnen und/oder Kontaktflächen gebildet werden, kurzgeschlossen werden können.

5. Chipmodul nach Anspruch 4,
**dadurch gekennzeichnet,**
**daß** die Unterbrechungen jeweils zwischen Teilen der Erhebung (23), die durch die elektrischen Leiterbahnen (16, 17) gebildet werden, und Teilen der Erhebung, die nicht durch die elektrischen Leiterbahnen gebildet werden, vorgesehen sind.

6. Chipmodul nach Anspruch 4 oder 5,
**dadurch gekennzeichnet,**
**daß** die Unterbrechungen eine Breite zwischen 10µm und 100µm aufweisen.

7. Chipmodul nach einem der vorstehenden Ansprüche,
**dadurch gekennzeichnet,**
**daß** die Teile der Erhebung (23), die durch die elektrischen Leiterbahnen (16, 17) gebildet werden, die selbe Höhe wie oder eine geringere Höhe als die Teile der Erhebung aufweisen, welche nicht durch die elektrischen Leiterbahnen gebildet werden.

## Claims

1. Chip module which can be implanted in a chip card body (25), having a carrier (10) to whose first main side a chip (13) is fitted, the carrier having contact areas (19) for making external contact on a second main side opposite the first main side, and a base-like elevation (23) which runs partly or wholly around the chip (13) being provided on the carrier, on which elevation a stiffening frame (22) or a casting mould for forming a chip covering that covers the chip (13) can be placed, **characterized in that** electric conductor tracks (16, 17) are fitted to the first main side of the carrier (10) and, at the points where they meet the elevation (23), are a constituent part of the elevation.

2. Chip module according to Claim 1, **characterized in that** the elevation (23) is formed by an electrically conductive structure fitted onto the carrier (10).

3. Chip module according to Claim 1 or 2, **characterized in that** the elevation (23) is a frame carrier essentially running all around the chip.

4. Chip module according to one of the preceding claims, **characterized in that** the elevation (23) has interruptions that are constructed and arranged in such a way that parts of the elevation that are formed by the electric conductor tracks (16, 17) cannot be short-circuited by parts of the elevation that are not formed by the electric conductor tracks and/or contact areas.

5. Chip module according to Claim 4, **characterized in that** the interruptions are in each case provided between parts of the elevation (23) that are formed by the electric conductor tracks (16, 17) and parts of the elevation that are not formed by the electric conductor tracks.

6. Chip module according to Claim 4 or 5, **characterized in that** the interruptions have a width of 10 µm and 100 µm.

7. Chip module according to one of the preceding claims, **characterized in that** the parts of the elevation (23) that are formed by the electric conductor tracks (16, 17) have the same height as or a lower height than the parts of the elevation that are not formed by the electric conductor tracks.

## Revendications

1. Module de puce qui peut être implanté dans un corps (25) de carte à puce comprenant un support (10) sur la première face principale duquel est déposée une puce (13), le support comportant, sur une deuxième face principale opposée à la première, des surfaces (19) de contact pour établir un contact avec l'extérieur et dans lequel il est prévu sur le support une surélévation (23) en forme de socle entourant la puce (13) en tout ou en partie, surélévation sur laquelle peut être posé un cadre (22) de rigidification ou un moule de coulée pour constituer un couvercle de puce recouvrant la puce (13),
**caractérisé en ce que** des pistes (16, 17) conductrices de l'électricité sont déposées sur la première face principale du support (10), et au point où elles rencontrent la surélévation (23) font partie de la surélévation.

2. Module de puce suivant la revendication 1, **caractérisé en ce que** la surélévation (23) est formée par une structure conductrice de l'électricité qui est déposée sur le support (10).

3. Module de puce suivant la revendication 1 ou 2, **caractérisé en ce que** la surélévation (23) est un support en forme de cadre entourant sensiblement complètement la puce.

4. Module de puce suivant l'une des revendications précédentes, **caractérisé en ce que** la surélévation (23) comporte des interruptions constituées et disposées de façon que des parties de la surélévation, qui sont formées par les pistes (16, 17) conductrices de l'électricité, ne puissent pas être court-circuitées par des parties de la surélévation, qui ne sont pas formées par les pistes conductrices de l'électricité et/ou les surfaces de contact.

5. Module de puce suivant la revendication 4, **caractérisé en ce qu'**il est prévu les interruptions respectivement entre des parties de la surélévation (23), qui sont formées par les pistes (16, 17) conductrices de l'électricité, et des parties de la surélévation, qui ne sont pas formées par les pistes conductrices de l'électricité.

6. Module de puce suivant la revendication 4 ou 5, **caractérisé en ce que** les interruptions ont une largeur comprise entre 10 µm et 100 µm.

7. Module de puce suivant l'une des revendications précédentes, **caractérisé en ce que** les parties de la surélévation (23), qui sont formées par les pistes (16, 17) conductrices de l'électricité, ont la même hauteur ou une hauteur plus petite que les parties de la surélévation qui ne sont pas formées par les pistes conductrices de l'électricité.
